# EUROPÄISCHE PATENTSCHRIFT

(11) **EP 0 494 420 B1**
(45) Veröffentlichungstag und Bekanntmachung des Hinweises auf die Patenterteilung: **05.06.1996**
(21) Anmeldenummer: 91121814.7
(22) Anmeldetag: 19.12.1991
(51) Int. Cl.: H03H 11/48

(54) **Stromsenke**
Current sink
Source négative de courant

(30) Priorität: 24.12.1990 DE 4041761
(43) Veröffentlichungstag der Anmeldung: 15.07.1992
(73) Patentinhaber: Alcatel SEL Aktiengesellschaft, D-70435 Stuttgart (DE); ALCATEL N.V., NL-1077 XX Amsterdam (NL)
(72) Erfinder: Benz, Paul, W-7000 Stuttgart 40 (DE)
(74) Vertreter: Pechhold, Eberhard, Dipl.-Phys.

(56) Entgegenhaltungen:
- WO-A-81/02819
- DE-A- 3 021 678
- DE-A- 3 629 938
- DE-A- 3 736 380
- US-A- 4 586 000
- Erwin Böhmer "ELEMENTE DER ANGEWANDTEN ELEKTRONIK", 5.Auflage, 1987,Vieweg Verlag, Braunschweig/Wiesbaden
- Dieter Nührmann: Professionelle Schaltungstechnik Teil 1, Franzis, München, DE, 1984, Seiten 44, 222, 223.

## Beschreibung

Die Erfindung betrifft eine Stromsenke gemäß dem Oberbegriff des Patentanspruchs 1.

Eine Stromsenke ist, wie eine Stromquelle auch, Teil jedes Stromkreises. Da sie meistens durch einen Verbraucher gebildet und als solcher bezeichnet wird, findet der Begriff Stromsenke fast immer nur dann Verwendung, wenn die Verbraucherfunktion als solche in den Hintergrund tritt, z.B. wenn verschiedenartige Ströme voneinander getrennt werden sollen, beispielsweise ein einem Gleichstrom aufgeprägtes Wechselstromsignal aus dem Gleichstromkreis kapazitiv ausgekoppelt und getrennt weiterverarbeitet werden soll. In diesem Fall muß parallel zur Auskoppelkapazität eine Gleichstromsenke zur Verfügung stehen, damit der Gleichstromfluß aufrechterhalten bleibt.

Eine solche Gleichstromsenke kann aus einem ohmschen Widerstand, einer Drossel oder auch aus einer als ohmscher oder induktiver Widerstand wirkenden Halbleiterschaltung bestehen.

So beschreibt die DE-OS 36 29 938 eine elektronische Drossel (Gyratorschaltung) zur Herstellung des Schleifenschlusses in Fernsprech-Nebenstellenanlagen, in der steuerbare Halbleiter (Darlington-Schaltungen) als Gleichstromsenken verwendet werden.

Eine Gleichstromsenke ist insbesondere erforderlich, wenn in optischen Empfängern das elektrische Ausgangssignal eines optoelektrischen Wandlers, einer PIN-Diode oder einer Avalanche-Photodiode (APD), verstärkt und ausgewertet werden soll. Hier liefert der optoelektrische Wandler ein elektrisches Ausgangssignal mit einem hohen Gleichstromanteil, dem das hochfrequente Nutzsignal über lagert ist. Ein dem optoelektrischen Wandler nachgeschalteter Breitbandverstärker wird, wenn ihm das Gleichstromsignal mit zugeführt wird, übersteuert oder durch Verschiebung der Arbeitspunkte seiner Verstärkerstufen in seinem Dynamikbereich eingeschränkt.

Der Einsatz einer herkömmlichen Stromsenke, z.B. eines dem Verstärkereingang parallel geschalteten ohmschen Widerstandes oder eines als Widerstand betriebenen Transistors, setzt den Eingangswiderstand des Verstärkers auch für das Wechselstromsignal herab und trägt in hohem Maße zum Rauschen bei. Er reduziert damit die Empfindlichkeit des Breitbandverstärkers. Letzteres erhöht, z.B. bei einer optischen Nachrichtenübertragungstrecke, die Zahl der benötigten Zwischenverstärker und wirkt sich damit unmittelbar auf die Kosten einer solchen Strecke aus. Die Parallelschaltung einer Drossel hoher Induktivität würde infolge ihrer unvermeidbaren Wicklungskapazität ebenfalls einen niedrigen Widerstand für das hochfrequente Nutzsignal mit sich bringen.

Der Erfindung liegt die Aufgabe zugrunde, mit geringem Schaltungsaufwand eine Stromsenke zu schaffen, die für Ströme in einem vorgegebenen Frequenzbereich hochohmig wirkt.

Diese Aufgabe wird durch die im Patentanspruch 1 angegebenen Merkmale gelöst.

Die Lösung ermöglicht z.B., als Stromsenke die Schaltstrecke eines Transistors (Patentanspruch 4) zu verwenden, diese aber so zu steuern, daß sie nur für Gleichstrom als Stromsenke wirkt, für Wechselstrom dagegen hochohmig bleibt.

Dies wird (gemäß Anspruch 2) durch Anordnung eines Kondensators zwischen Basis und Emitter des Transistors erreicht. Da der Kondensator für Wechselstrom einen Kurzschluß darstellt, werden am Emitter des Transistors anliegende Wechselspannungsamplituden in nahezu voller Höhe auf dessen Basisanschluß übertragen. Die Basis-Emitterspannung sowie der Basisstrom und damit der über die Kollektor-Emitter-Strecke des Transistors fließende (Gleich)strom bleiben unverändert. Die für Gleichstrom niederohmige Schaltstrecke des Transistors beeinflußt damit ein der Emitterspannung überlagertes Wechselspannungssignal nicht. Die Stromsenke ist damit für Wechselspannung hochohmig.

Wird gemäß Anspruch 3 anstelle eines Kondensators ein Filter verwendet, so kann die Stromsenke frequenzselektiv ausgestaltet werden. Es können dann z.B. alle Frequenzen außerhalb eines durch das Filter bestimmten Bereiches durch die Stromsenke bedämpft und damit die Filterwirkung verbessert werden.

Eine in Anspruch 5 beschriebene Ausgestaltung der Erfindung sieht anstelle eines gewöhnlichen Transistors einen Transistor mit hochohmigem Steuereingang vor. Solche hochohmigen Steuereingänge weisen insbesondere Feldeffekttransistoren auf. Es können jedoch auch Schaltungen mit mehreren Transistorfunktionen, z.B. Operationsverstärker, wie in Anspruch 6 angegeben, als das den Senkenstrom aufnehmende elektronische Bauelement Verwendung finden. Da hier der über den Steueranschluß fließende Strom vernachlässigt werden kann, kann ein zur Einstellung der Steuerspannung erforderlicher Spannungsteiler extrem hochohmig ausgeführt werden, was eine kostengünstige Dimensionierung des zwischen Schaltstrompfad und Steueranschluß anzuordnenden Bauelements ermöglicht.

Eine Ausgestaltung der Erfindung ist im Anspruch 7 angegeben und ermöglicht eine Doppelausnutzung des zwischen Schaltstrompfad und Steueranschluß anzuordnenden Bauelements als Teil der Stromsenke und zur Auskopplung des Nutzsignales aus dem über die Stromsenke führenden Stromkreis.

Die Ansprüche 8 und 9 betreffen Verwendungen der Stromsenke nach der Erfindung zusammen mit Breitbandverstärkern, wie sie z.B. zur optischen Nachrichtenübertragung zusammen mit optischen Wandlern Verwendung finden. Nach Anspruch 9 wird die Stromsenke zusätzlich zum Schutz eines Breitbandverstärkers vor Übersteuerung genutzt.

Anhand von drei Figuren sollen nun Ausführungsbeispiele der Erfindung eingehend beschrieben werden.
- Fig. 1: zeigt die Erfindung am Beispiel einer Gleichstromsenke.
- Fig. 2: zeigt die Erfindung in einem optoelektrischen Empfänger.
- Fig. 3: zeigt die Erfindung zur Verbesserung eines Bandpasses.

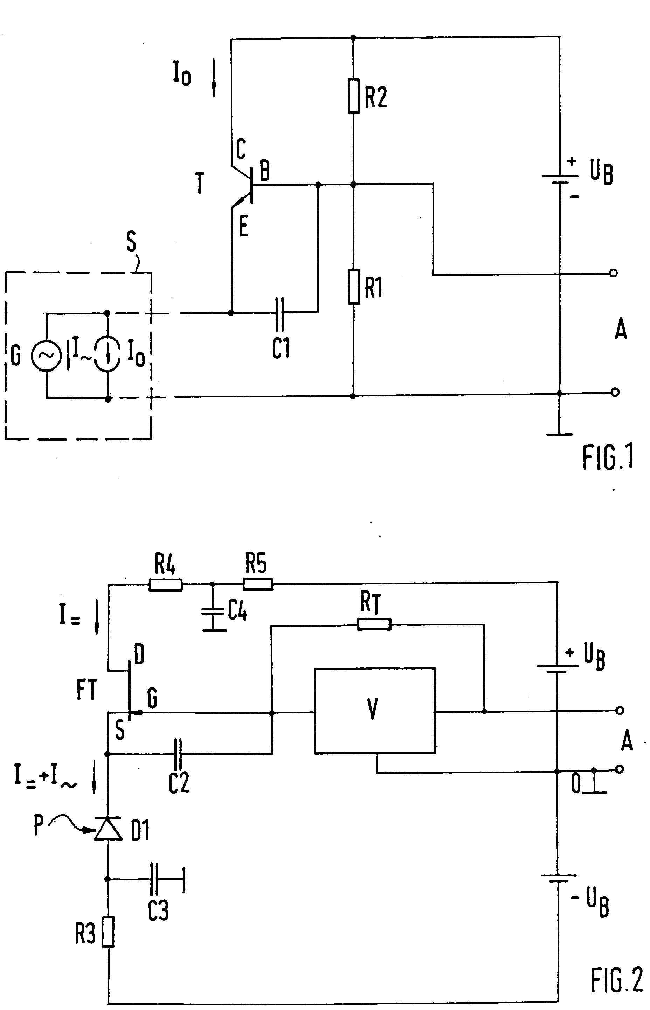

In Fig. 1 ist ein Bipolartransistor T mit seinem Schaltstrompfad CE in einen Stromkreis geschaltet, welcher von der positiven Klemme einer Gleichspannungsquelle U_{B} über den Transistor T und eine Signalquelle S zur negativen Klemme der Spannungsquelle U_{B} verläuft. Parallel zur Spannungsquelle U_{B} liegt ein aus Widerständen R1, R2 bestehender Spannungsteiler, der ein bestimmtes Basispotential für den Transistor einstellt und dessen Teilerpunkt mit dem Basisanschluß B des Transistors T verbunden ist. Die Signalquelle S besitzt einen nicht zu kleinen ohmschen Widerstand und ist in der Lage, einen über die Kollektor-Emitter-Strecke des Transistors zugeführten Gleichstrom zur negativen Klemme der Spannungsquelle U_{B} abzuführen.

In stationärem Zustand fließt im Stromkreis somit bei vorgegebener Spannung U_{B} ein durch den Gleichstromwiderstand der Signalquelle und durch das Basispotential und die Stromverstärkung des Transistors T bestimmter Strom I₀. Die Basis-Emitter-Spannung des Transistors T nimmt einen festen Wert an, da ein zwischen Basis und Emitter des Transistors geschalteter Kondensator C1 nach kurzer Zeit auf die Basis-Emitter-Spannung des Transistors aufgeladen ist. Die Kollektor-Emitter-Strecke (Schaltstrompfad) des Transistors wirkt als Stromsenke für den aus der Signalquelle S fließenden Strom.

Gibt die Signalquelle S jedoch zusätzlich ein Wechselstromsignal ab, wie dies z.B. ein akustisch/elektrischer oder optisch/elektrischer Wandler vermag, so treten am Ausgang der Signalquelle und damit auch am Emitter des Transistors Spannungsänderungen auf. Wäre der Kondensator C1 nicht vorhanden, so würden diese Änderungen durch den Transistor stark bedämpft, da der Signalquellenwiderstand als Gegenkopplung wirken würde. Die durch den Transistor gebildete Stromsenke würde sich somit auch auf den Wechselstrom auswirken.

Gemäß der Erfindung ist nun zwischen Emitter- und Basisanschluß des Transistors der Kondensator C1 vorgesehen. Dieser stellt einen Wechselstromkurzschluß dar und sorgt dafür, daß am Emitter des Transistors auftretende Wechselspannungen in nahezu voller Höhe auf die Basis des Transistors übertragen werden, so daß sich die Basis-Emitter-Spannung und damit auch der Widerstand der Kollektor-Emitter-Strecke nicht ändern, die Gegenkopplung damit für Wechselspannung nicht wirksam wird. Das Wechselspannungssignal ist damit am Emitteranschluß des Transistors oder auch am Basisanschluß des Transistors in nahezu voller Höhe vorhanden und kann, wie in Fig. 1 dargestellt, an einem Ausgang A zur Weiterverarbeitung entnommen werden. Durch die Auskoppelung des Wechselspannungssignals am Basisanschluß des Transistors wird der Kondensator C1 als Auskoppelkapazität mit genutzt. Bei Auskoppelung am Emitteranschluß des Transistors müßte eine getrennte Auskoppelkapazität zusätzlich vorgesehen werden.

Der Betrieb eines Bipolar-Transistors erfordert zumindest einen geringen Basisstrom. Die Spannungsteilerwiderstände R1 und R2 dürfen deshalb nicht beliebig hochohmig sein. Um das Wechselspannungssignal trotz Basisstroms und endlichen Teilerwiderständen möglichst in voller Höhe vom Emitteranschluß auf den Basisanschluß zu übertragen, bedarf es deshalb eines relativ großen Kondensators C1. Auch darf der Signalquellenwiderstand nicht zu hochohmig sein. Diese Zwänge lassen sich vermeiden, wenn anstelle eines Bipolartransistors ein Feldeffekttransistor verwendet wird.

Der Einsatz eines Feldeffekttransistors als für Wechselstrom hochohmige Gleichstromsenke ist in Fig. 2 am Beispiel eines optisch/elektrischen Empfängers dargestellt. Als Signalquelle dient hier eine PIN-Diode D1, die z.B. aus einem optischen Wellenleiter austretendes Licht in ein hochfrequentes elektrisches Signal umwandelt. Die Kathode der PIN-Diode ist mit dem Source-Anschluß eines Feldeffekttransistors (FET) FT verbunden. Die Source-Gate-Strecke des FET ist durch einen Kondensator C2 überbrückt. Mit dem Gate-Anschluß G des FET ist der Eingang eines Transimpedanzverstärkers V verbunden, an dessen Ausgang A das von der PIN-Diode empfangene, verstärkte hochfrequente Nutzsignal entnommen wird. Eingang und Ausgang des Transimpedanzverstärkers V sind durch einen Transimpedanzwiderstand R_{T} verbunden.

Der Betriebsstrom der PIN-Diode kommt aus zwei in Reihe liegenden Spannungsquellen +U_{B}, -U_{B}, deren Mittelpunkt das Bezugspotential (Masse) bildet, und wird der PIN-Diode über den Drain-Anschluß des FET zugeführt. Anodenseitig ist der PIN-Diode D1 ein Siebglied, bestehend aus einem Widerstand R3 und einem Kondensator C3 vorgeschaltet. In der Zuleitung zum Drain-Anschluß des FET liegen in Reihe zwei Widerstände R4 und R5, deren Verbindungspunkt zur Aussiebung von Störspannungen und zur Hochfrequenzableitung über einen Kondensator C4 mit Bezugspotential verbunden ist und deren Funktion weiter unten erklärt wird. Der Kondensator C3 des Siebgliedes bildet einen Hochfrequenzkurzschluß und legt die Anode der PIN-Diode hochfequenzmäßig auf Bezugspotential.

Die PIN-Diode liefert, wie die Signalquelle S in der in Fig. 1 beschriebenen Schaltung, ein Signal mit einem Gleichstromanteil und einem Wechselstromanteil. Während der Gleichstrom über die für Gleichstrom niederohmige Schaltstrecke des FET abfließt, bleibt der Wechselstromanteil, für den der FET einen sehr hochohmigen Widerstand darstellt, ungeschwächt. Würde der Gleichstromanteil ebenfalls dem Transimpedanzverstärker zugeführt, so würde er dessen Dynamik reduzieren. Durch den Einsatz des FET als Gleichstromsenke wird ein Dynamik-Gewinn von etwa 6 dB erreicht.

Die Widerstände R4 und R5 in Fig. 2 ermöglichen, den FET zusätzlich als Übersteuerungsschutz für den Transimpedanzverstärker zu verwenden. Es wird hier ausgenutzt, daß mit steigendem hochfrequentem Lichtanteil eines optischen Signals auch der Gleichstrom durch die PIN-Diode zunimmt. Dieser Gleichstrom führt zu einem Spannungsabfall an den Widerständen R4 und R5, wobei der niederohmige Strombegrenzungswiderstand R4 nur wenig zum Spannungsabfall beiträgt, und zu einer Verschiebung des Arbeitspunktes des FET in Richtung des Anlaufbereichs des FET-Kennlinienfeldes. Wird der Widerstand R5 so ausgelegt, daß der Arbeitspunkt bei Übersteuerung weit in diesen Anlaufbereich verlagert wird, so wirkt die Source-Drain-Strecke als niederohmiger Shunt-Widerstand am Eingang des Transimpedanz-Verstärkers und verhindert dessen Übersteuerung.

Die Wirkung der Widerstände R4 und R5 kann auch durch einen das Drain-Potential des FET beeinflussenden Regelkreis erzielt werden, welcher abhängig vom Ausgangssignal des Transimpedanzverstärkers V arbeitet. Der FET arbeitet dann als Stellglied in einem geschlossenen Regelkreis.

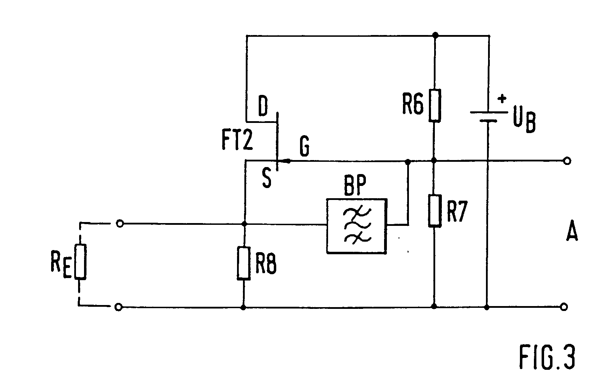

Fig. 3 zeigt, daß die Stromsenke nach der Erfindung nicht nur als Gleichstromsenke Verwendung finden kann, sondern auch als Senke für Gleichstrom und Wechselströme. Wie in Fig. 2 ist hier der Source-Anschluß eines FET FT2 mit einer Signalquelle verbunden, die aus einem Widerstand R8 und einer parallelliegenden, mit einem komplexen Widerstand R_{E} behafteten, ein Fequenzgemisch abgebenden Quelle bestehen soll. Der Drain-Anschluß des FET ist mit der positiven Klemme einer Spannungsquelle U_{B} verbunden. Dieser ist ein aus Widerständen R6 und R7 bestehender Spannungsteiler zur Einstellung des Gate-Potentials des FET parallelgeschaltet.

Anstelle eines Koppelkondensators ist hier ein Bandpaß BP zwischen Source-Anschluß und Gate-Anschluß des FET geschaltet. Der Schaltstrompfad des FET wirkt damit als Stromsenke für alle Ströme, die nicht Wechselströme mit einer im Durchlaßbereich des Bandpasses liegenden Frequenz sind. Nur für vom Bandpaß durchgelassene Wechselströme ist der FET hochohmig. Er verbessert damit die Wirkung des Bandpasses.

Anstelle eines Bandpasses können auch andere Bauelemente mit frequenzabhängigen Durchlaßbereichen eingesetzt und in ihrer Wirkung verbessert werden.

## Patentansprüche

1. Stromsenke, die nur den Gleichstromanteil eines einen Gleichstromanteil und einen Wechselstromanteil enthaltenden Nutzsignals aufnimmt, mit einem elektronischen Bauelement (T, FT, FT2), das neben einem Steueranschluß (8, 6) einen der Aufnahme des Senkenstromes dienenden, niederohmig steuerbaren Schaltstrompfad (C-E, D-J) aufweist,
**dadurch gekennzeichnet,** daß der Eingang (E, S) des Schaltstrompfades mit dem Steueranschluß (B, G) über ein einen frequenzabhängigen Durchlaßbereich aufweisendes Bauelement (C1, C2) oder einen einen frequenzabhängigen Durchlaßbereich aufweisenden Schaltkreis (BP) verbunden ist.

2. Stromsenke nach Anspruch 1, dadurch gekennzeichnet, daß als einen frequenzabhängigen Durchlaßbereich aufweisendes Bauelement ein Kondensator (C1, C2) vorgesehen ist.

3. Stromsenke nach Anspruch 1, dadurch gekennzeichnet, daß als einen frequenzabhängigen Durchlaßbereich aufweisendes Bauelement ein aktives oder passives Filter vorgesehen ist.

4. Stromsenke nach einem der Ansprüche 1 bis 3, dadurch gekennzeichnet, daß als einen niederohmig steuerbaren Schaltstrompfad aufweisendes elektronisches Bauelement ein Transistor (T) verwendet wird.

5. Stromsenke nach Anspruch 4, dadurch gekennzeichnet, daß der Transistor (T) ein Transistor mit hochohmigem Steuereingang, insbesondere ein Feldeffekttransistor (FT, FT2) ist.

6. Stromsenke nach einem der Ansprüche 1 bis 3, dadurch gekennzeichnet, daß als einen niederohmigen Schaltstrompfad aufweisendes elektronisches Bauelement ein Operationsverstärker verwendet wird.

7. Stromsenke nach einem der vorstehenden Ansprüche, dadurch gekennzeichnet, daß das einen frequenzabhängigen Durchlaßbereich aufweisende Bauelement (C1, C2) gleichzeitig zur Auskopplung eines Wechselspannungssignals aus einem Gleichstromkreis dient.

8. Verwendung einer Stromsenke gemäß einem der vorstehenden Ansprüche zur Ableitung eines im Ausgangssignal eines optoelektrischen Wandlers enthaltenen Gleichstromanteils.

9. Stromsenke nach einem der Ansprüche 1 bis 7, zur gleichzeitigen Verwendung als Stromsenke und als Schutz vor Übersteuerung eines mit dem Eingang der Stromsenke verbundenen Breitbandverstärkers, dadurch gekennzeichnet, daß im Ausgang des den Senkenstrom aufnehmenden Schaltstrompfades mindestens ein Widerstand (R5) oder eine abhängig vom Ausgangssignal des Breitbandverstärkers steuerbare Regelschaltung vorgesehen sind, die das Potential des Ausgangsanschlusses des den Senkenstrom aufnehmenden Schaltstrompfades abhängig vom Senkenstrom bzw. abhängig vom Ausgangssignal des Breitbandverstärkers verändern.

10. Verwendung einer Stromsenke gemäß einem der Ansprüche 1 bis 7 zur Verbesserung des Frequenzganges und zur Herabsetzung der Übersteuerungsgefahr bei Filtern.

## Claims

1. A current sink which sinks only the direct-current component of a useful signal containing a direct-current component and an alternating-current component, said current sink comprising an electronic component (T, FT, FT2) having a control terminal (B, G) and a switched current path (C-E, D-S), the switched current path serving to sink the sink current and being switchableto a low-impedance condition,
**characterized in**
that the input (E, S) to the switched current path is connected to the control terminal (B, G) via a component (C1, C2) or circuit (BP) having a frequency-dependent passband.

2. A current sink as claimed in claim 1, characterized in that the component having a frequency-dependent passband is a capacitor (C1, C2).

3. A current sink as claimed in claim 1, characterized in that the component having a frequency-dependent passband is an active or passive filter.

4. A current sink as claimed in any one of claims 1 to 3, characterized in that the electronic component having a switched current path switchable to a low-impedance condition is a transistor (T).

5. A current sink as claimed in claim 4, characterized in that the transistor (T) is a transistor having a high-resistance control input, particularly a field-effect transistor (FT, FT2).

6. A current sink as claimed in any one of claims 1 to 3, characterized in that the electronic component having a switched current path switchable to a low-impedance condition is an operational amplifier.

7. A current sink as claimed in any one of the preceding claims, characterized in that the component (C1, C2) having a frequency-dependent passband also serves to remove an alternating-voltage signal from a direct-current circuit.

8. Use of a current sink as claimed in any one of the preceding claims for deriving a direct-current component contained in the output of an optical-to-electrical transducer.

9. A current sink as claimed in any one of claims 1 to 7, for use both as a current sink and as protection against overloading of a broadband amplifier connected to the input of the current sink, characterized in that in the output of the switched current path sinking the sink current, at least one resistor (R5) or a control circuit responsive to the output signal of the broadband amplifier is provided for varying the potential of the output terminal of the switched current path in accordance with the sink current or with the output signal of the broadband amplifier, respectively.

10. Use of a current sink as claimed in any one of claims 1 to 7 to improve the frequency response of a filter and reduce the risk of a filter being overloaded.

## Revendications

1. Récepteur de courant ne recevant que la proportion de courant continu d'un signal utile comportant une proportion de courant continu et une proportion de courant alternatif, comportant un composant électronique (T, FT, FT2) qui présente, à côté d'une borne de commande, (B, G) une ligne de courant de commutation (C-E, D-S), caractérisé en ce que l'entrée (E, S) de la ligne de courant de commutation est reliée à la borne de commande (B, G) par l'intermédiaire d'un composant (C1, C2) présentant une plage passante dépendante de la fréquence ou un circuit de commutation (BP) présentant une plage passante dépendante de la fréquence.

2. Récepteur de courant suivant la revendication 1, caractérisé en ce qu'un condensateur (C1, C2) joue le rôle d'un composant présentant une plage passante dépendante de la fréquence.

3. Récepteur de courant suivant la revendication 1, caractérisé en ce qu'un filtre actif ou passif joue le rôle d'un composant présentant une plage passante dépendante de la fréquence.

4. Récepteur de courant suivant l'une des revendications 1 à 3, caractérisé en ce qu'un transistor (T) joue le rôle d'un composant électronique présentant une ligne de courant de commutation réglable de faible impédance.

5. Récepteur de courant suivant la revendication 4, caractérisé en ce que le transistor (T) est un transistor comportant une entrée de commande à haute impédance, en particulier un transistor à effet de champ (FT, FT2).

6. Récepteur de courant suivant l'une des revendications 1 à 3, caractérisé en ce qu'un amplificateur d'opération est utilisé comme composant électronique présentant une ligne de courant de commutation de faible impédance.

7. Récepteur de courant suivant l'une des revendications précédentes, caractérisé en ce qu'un composant (C1, C2) présentant une plage passante dépendante de la fréquence sert en même temps à découpler un signal de tension alternative d'un circuit de courant continu.

8. Utilisation d'un récepteur de courant suivant l'une des revendications précédentes, pour dériver une proportion de courant continu contenue dans le signal de sortie d'un convertisseur optoélectronique.

9. Récepteur de courant suivant l'une des revendications 1 à 7, pour utilisation simultanée comme récepteur de courant et comme protection contre la surmodulation d'un amplificateur à large bande relié à l'entrée du récepteur de courant, caractérisé en ce qu'à la sortie de la ligne de courant de commutation recevant le courant de réception sont prévus au moins une résistance (R5) ou un circuit de réglage, réglable en fonction du signal de sortie de l'amplificateur à large bande, lesquels résistance et circuit modifient le potentiel de la borne de sortie de la ligne de courant de commutation recevant le courant de réception en fonction du courant de réception ou en fonction du signal de sortie de l'amplificateur à large bande.

10. Utilisation d'un récepteur de courant suivant l'une des revendications 1 à 7, pour améliorer la réponse en fréquences, ou pour diminuer le risque de surmodulation lorsque des filtres sont employés.
